# EUROPEAN PATENT SPECIFICATION

(11) **EP 0 598 476 B1**
(45) Date of publication and mention of the grant of the patent: **12.07.2000**
(21) Application number: 93307288.6
(22) Date of filing: 15.09.1993
(51) Int. Cl.: G06F 9/45, G06F 17/50

(54) **Compilation mechanism for a simulation model**
Kompilierungsmechanismus für Simulationsmodelle
Mécanisme de compilation pour un modèle de simulation

(30) Priority: 19.11.1992 GB 9224225
(43) Date of publication of application: 25.05.1994
(73) Proprietor: INTERNATIONAL COMPUTERS LIMITED, Putney, London, SW15 1SW (GB)
(72) Inventor: Shaar, Zakwan, Heaton Mersey, Stockport, SK4 2DG (GB)
(74) Representative: Guyatt, Derek Charles

(56) References cited:
- IEEE INTERNATIONAL CONFERENCE ON COMPUTER-AIDED DESIGN, 5 November 1989, SANTA CLARA CA US pages 176 - 179 ACOSTA ET AL 'mixed-mode simulation of compiled vhdl programs'
- IEEE INTERNATIONAL CONFERENCE ON COMPUTER DESIGN : VLSI IN COMPUTERS & PROCESSORS, 2 October 1989, CAMBRIDGE MASS US pages 542 - 547 ABRAMOVICI ET AL 'system-level design verification in the at&t computer division : overview and strategy'
- IEEE INTERNATIONAL CONFERENCE ON COMPUTER DESIGN : VLSI IN COMPUTERS & PROCESSORS, 2 October 1989, CAMBRIDGE MASS US pages 548 - 554 ABRAMOVICI ET AL 'system-level desgn verification in the at&t computer division : tools'
- EUROPEAN CONFERENCE ON ELECTRONIC DESIGN AUTOMATION, 26 March 1984, WARWICK GB pages 107 - 110 HODGSON 'a multilevel, mixed state simulator for hierarchical design verification'

## Description

### Background to the Invention

This invention relates to a compilation mechanism for generating a simulation model of a logic system.

Simulation models are widely used as design aids in the design and development of complex logic systems, such as computer systems. Such simulation models are generally implemented by means of software, running on general-purpose computer hardware. However, in principle, they could alternatively be implemented using special purpose hardware techniques.

The design of a logic system may be represented by a number of design units, connected together in a network in a specified manner. Each of these units may be represented by a behaviour specification, ie a set of rules or algorithms that specify the behaviour of the unit. Alternatively, a design unit may be represented by a sub-network of lower-level design units, each of which in turn may be represented either by a behaviour specification or a sub-network. In other words, the design can be specified as a hierarchical network. A compiler program can be used to generate a simulation model for the system from these design units.

It has been found that for complex designs comprising several VLSI chips (each chip typically equivalent to 50-100 thousand gates), the compilation time can be excessively high (running into hours on a mainframe computer) due to the many levels of hierarchy and the complexity of the sub-networks. Another problem with this is that, if changes are made to any of the design units in the course of development of the design, the whole simulation model must be recompiled no matter how small the changes. This is extremely time consuming and severely restricts designer productivity.

The object of the present invention is to overcome or alleviate this problem and also to speed up the compilation process for large simulation models as a whole.

### Summary of the Invention

According to the invention as defined in claim 1 there is provided a computer system for generating a simulation model of a digital electronic system consisting of a plurality of design units, the computer system comprising:
a) a design database storing a plurality of network objects each network object defining one of said design units in terms of a sub-network of further design units, the design database also storing a plurality of previously compiled sub-models for simulating respective design units,
b) compilation means for using said network objects in the design database to expand a selected design unit as a sub-network of further design units, and for generating a list of compiled sub-models stored in said design database for simulating those further design units, and
c) linking means for linking together the compiled sub-models on said list, to produce a compiled simulation model for said selected design unit.

A corresponding method of generating a simulation model is defined in claim 4.

This pre-compiled sub-model may be derived by a previous invocation of the same compilation mechanism on the sub-network. A simulation model hierarchy, similar to the network hierarchy, can therefore be constructed. This is the "compile" option of the compilation mechanism. Another option of the compilation mechanism, herein referred to as the "link" option, allows an existing simulation model to be updated following modification of a sub-model forming part of that model. The modified sub-network is first compiled using the compile option. The new sub-model is then linked into the simulation model in place of the existing sub-model.

In a preferred embodiment of the invention, at least one of the design units may be expanded as both a sub-model and a behaviour arranged within the model such that they will execute in parallel during simulation.

The concept of employing pre-compiled sub-models in the compilation alleviates the need to expand the sub-networks and therefore significantly reduces the compilation time. Experience has shown that large model builds using this system can be achieved in minutes rather than hours.

It will be seen that the invention also allows incremental compilation of a simulation model, providing the ability to carry out design changes without a major recompilation overhead. This is of particular benefit when making minor changes to large designs, and it has been found that designer productivity can be substantially increased as a result.

### Brief Description of the Drawings

Figure 1 is a data flow diagram of a compilation mechanism for generating a simulation model, including a compiler and a linker.

Figure 2 is a flow chart showing the operation of the compiler when executing a "compile" option.

Figure 3 is a flow chart showing the operation of the linker.

Figure 4 is a flow chart showing the operation of the compiler when executing a "link" option.

Figure 5 is a schematic diagram illustrating an example of operation of the compilation mechanism.

### Description of an Embodiment of the Invention

One compilation mechanism in accordance with the present invention will now be described by way of example with reference to the accompanying drawings.

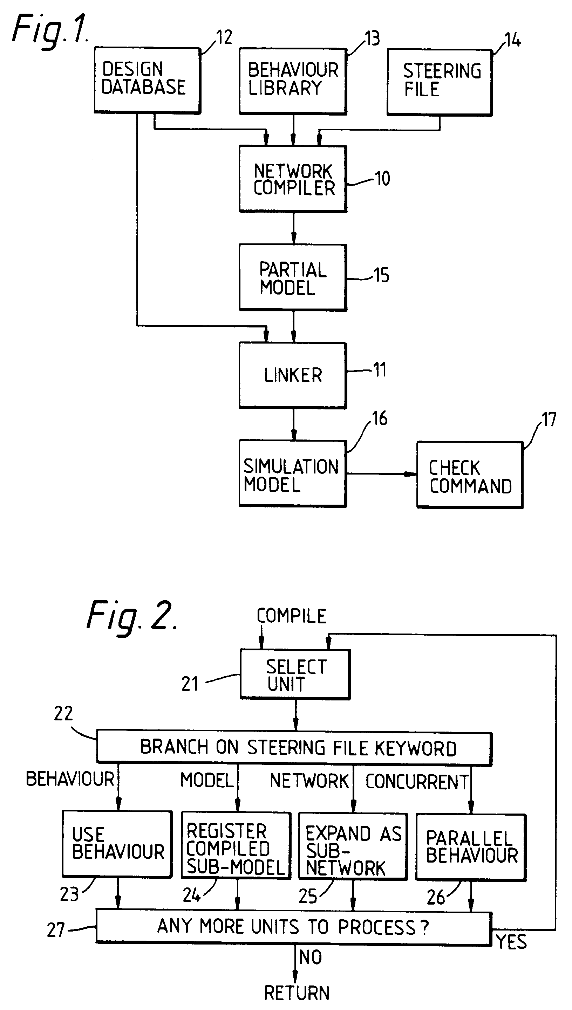

Referring to Figure 1, the compilation mechanism includes a network compiler 10, and a linker 11. The compiler 10 makes use of a design database 12, a behaviour library 13 and a compiler steering file 14. As will be described, the compiler 10 generates a partial model 15 which is then processed by the linker 11 to produce a compiled simulation model 16.

The design database 12 consists of a collection of data objects, each having a unique name. These objects include a plurality of network objects, each of which defines a design unit in terms of a sub-network. The design database also holds any simulation models that have already been generated by the network compiler. In general, these models include a top-level simulation model of the system to be simulated, and may also include a number of sub-models for individual parts of the system. Each model has associated with it a list of sub-models (if any) that have been used in generating that model, as will be described in more detail later.

The behaviour library 13 consists of a collection of compiled behaviour specifications, each of which specifies the behaviour of a design unit in terms of a set of rules or algorithms.

The compiler steering file 14 comprises a set of statements of the form:
(keyword, name)
Where "name" is the name of a particular design unit, and "keyword" is one of the following options.
Behaviour - simulate the design unit by means of a behavioural simulation, ie in terms of its behaviour specification.
Model - use a previously compiled sub-model to simulate the design unit.
Network - expand the design unit in terms of a sub-network.
Concurrent - simulate the design unit in terms of its behaviour specification and also expand the unit as a sub-network (or use a previously compiled sub-model if the unit is also specified as a model), in parallel with the behavioural simulation.

A CHECK command 17 is also provided, for checking that during simulation the outputs of concurrently compiled behaviour and sub-network (or sub-model) are the same.

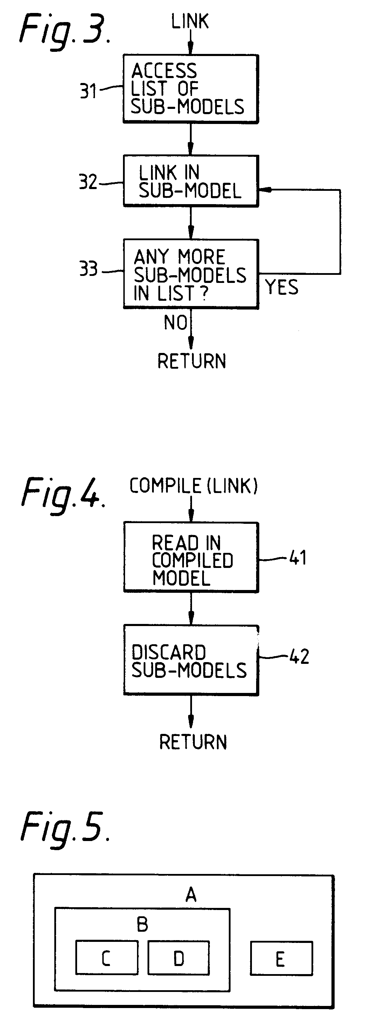

Referring now to Figure 2, this shows the operation of the compiler 10 in response to a COMPILE command, specifying that a simulation model is to be generated for a particular top-level design unit.
(21) The compiler first selects a design unit from the database 12 for processing. Initially, this is the top-level design unit.
(22) The compiler then examines the steering file 14 to find a statement relating to the selected design unit. The compiler branches according to the keyword in the statement.
(23) If the keyword is "Behaviour", the compiler fetches the behaviour specification for the design unit from the behaviour library 13 and records a reference to it in the partial model 15. This specification contains the simulation code necessary for simulating the behaviour.
(24) If the keyword is "Model", the compiler finds a previously compiled sub-model for the design unit from the design database, and updates a list of sub-models in the partial model 15 for subsequent linking. If no previously compiled sub-model can be found, an error message is returned.
(25) If the keyword is "Network", the compiler expands the selected design unit, by replacing it with a sub-network, obtained from the design database 14. All the design units in the sub-network then become available for processing.
(26) If the keyword is "Concurrent", the compiler performs the actions specified above for "Behaviour", arranging the behaviour in parallel with an existing network or sub-model, so that the compiled simulation model will contain both the behavioural representation and a sub-network expansion (or compiled sub-model) of the design unit in parallel.
   If no statement can be found in the steering file for the design unit, the compiler looks for a behaviour first, a model second and a network last. If one of these is found, the compiler proceeds as described above. Otherwise an error message is returned.
(27) If there are now no more design units for processing, the compilation is complete. Otherwise, the compiler returns to step 21 above, to select the next design unit for processing.
   Referring now to Figure 3, this shows the operation of the linker 16.
(31) The link command accesses the list of compiled sub-models (if any) associated with the partial model 15.
(32) For each sub-model in the list, the linker fetches this sub-model from the design database 12 and links it in to the simulation model 16, performing any necessary "fixing-up" of references.
(33) The above step is repeated for each sub-model in the list in turn.
   When the simulation model 16 has been generated and linked, it can be run, using suitable input test data sequences. Where the simulation model contains concurrent representations of a design unit in terms of its behaviour and its network expansion (or sub-model), the results of these two representations can be compared, to check for equivalence, using the CHECK command 17.
   Referring now to Figure 4, this shows the operation of the compiler 10 in response to a COMPILE (LINK) command. This option is used in order to update an existing simulation model, following modification of a sub-model forming part of that model.
(41) The model to be updated is read from the design database 12 and is stored as the full model 16.
(42) All sub-models within the model 16 are discarded to produce the partial model 15.
   The partial model 15 can then be processed by the linker 11, as described above, to link in the latest versions of all the sub-models in its associated list of sub-models.

An example of the operation of the compiler mechanism will now be described with reference to Figure 5.

In this example, it is assumed that a top-level design A comprises design units B and E. Unit B has been expanded as a sub-network consisting of design units C and D. It is also assumed that, in the course of developing the simulation model for A, sub-models have been compiled for units B and C.

Suppose now a minor change is made to the simulation model, by making modifications to unit C. In this case, the COMPILE option of the compiler 10 is first called to re-compile the sub-model for unit C. The COMPILE (LINK) option is then called to update the sub-model for unit B. Finally, the COMPILE (LINK) option is called again to update the model for the top-level design A.

Consider now the case where a more extensive change has been made to the simulation model, affecting both unit C and the way in which this unit interacts with unit B. In this case, the COMPILE option of the compiler is first called to re-compile the sub-model for unit C. The COMPILE option is then called again, to re-compile the sub-model for unit B. Finally, the COMPILE (LINK) option is called, to update the top-level design A.

It can be seen from this example that the amount of re-compilation required in both cases is less than if the whole model had to be re-compiled. Moreover, the amount of re-compilation depends on the extent of the changes: smaller changes require less recompilation.

## Claims

1. A computer system for generating a simulation model of a digital electronic system consisting of a plurality of design units, the computer system comprising:
a) a design database storing a plurality of network objects, each network object defining one of said design units in terms of a sub-network of further design units, the design database also storing a plurality of previously compiled sub-models for simulating respective design units,
b) compilation means for using said network objects in the design database to expand a selected design unit as a sub-network of further design units, and for generating a list of compiled sub-models stored in said design database for simulating those further design units, and
c) linking means for linking together the compiled sub-models on said list, to produce a compiled simulation model for said selected design unit.

2. A computer system according to Claim 1 further comprising means for updating an existing simulation model following a change to a sub-model that forms part of it, by linking a later version of a sub-model into the simulation model in place of an existing sub-model.

3. A computer system according to Claim 1 or 2, further including a steering file comprising a set of statements, each specifying whether a design unit is to be expanded as a sub-network, represented in terms of its behaviour specification, simulated by a previously compiled sub-model, or concurrently compiled as behavioural specification arranged in parallel with said sub-model or sub-network.

4. A method of generating a simulation model of a digital electronic system consisting of a plurality of design units, the method comprising the steps:
a) creating a design database holding a plurality of network objects, each network object defining one of said design units in terms of a sub-network of further design units, the design database also holding a plurality of previously compiled sub-models for simulating respective design units,
b) using said network objects in the design database to expand a selected design unit as a sub-network of further design units, and generating a list of compiled sub-models stored in said design database for simulating those further design units, and
c) linking together the compiled sub-models on said list, to produce a compiled simulation model for said selected design unit.

## Patentansprüche

1. Rechnersystem zum Erzeugen eines Simulationsmodells eines digitalen elektronischen Systems, das aus einer Mehrzahl von Konstruktionseinheiten besteht, gekennzeichnet durch
a) eine Konstruktions-Datenbank, die eine Mehrzahl von Netzwerkobjekten speichert, deren jedes eine der Konstruktionseinheiten in Form eines Teil-Netzwerkes weiterer Konstruktionseinheiten definiert, wobei die Konstruktions-Datenbank ferner eine Mehrzahl von vorher kompilierten Teil-Modellen zum Simulieren entsprechender Konstruktionseinheiten speichert,
b) eine Kompiliervorrichtung zur Verwendung der Netzwerk-Objekte in der Konstruktions-Datenbank, um eine ausgewählte Konstruktionseinheit als ein Teil-Netzwerk weiterer Konstruktionseinheiten zu erweitern, und um eine Liste von kompilierten Teil-Modellen zu erzeugen, die in der Konstruktionsdatenbank zum Simulieren dieser weiteren Konstruktionseinheiten gespeichert sind, und
c) eine Kopplungsvorrichtung zum Verkoppeln der kompilierten Teil-Modelle der kompilierten Teil-Modelle auf de Liste, um ein kompiliertes Simulationsmodell für die ausgewählte Konstruktionseinheit zu erzeugen.

2. Rechnersystem nach Anspruch 1, gekennzeichnet durch eine Vorrichtung zum Fortschalten eines vorhandenen Simulationsmodells im Anschluß an eine Änderung in ein Teil-Modell, das einen Teil davon bildet, indem eine spätere Version eines Teil-Modells in das Simulations-Modell anstelle eines vorhandenen Teil-Modells gekoppelt wird.

3. Rechnersystem nach Anspruch 1 oder 2, gekennzeichnet durch eine Steuerungsdatei, die einen Satz von Statements umfasst, deren jedes angibt, ob eine Konstruktionseinheit als ein Teil-Netzwerk erweitert wird, das in Form seiner Verhaltens-Spezifikation dargestellt wird, durch ein vorher kompilierters Teil-Modell simuliert wird, oder gleichzeitig als Verhaltens-Spezifikation kompiliert wird, die parallel zu dem Teil-Modell oder Teil-Netzwerk angeordnet ist.

4. Verfahren zum Erzeugen eines Simulationsmodells eines digitalen elektronischen Systems, das aus einer Mehrzahl von Konstruktionseinheiten besteht, dadurch gekennzeichnet, daß
a) eine Konstruktions-Datenbank erzeugt wird, die eine Mehrzahl von Netzwerk-Objekten aufnimmt, deren jedes eine der Konstruktionseinheiten in Form eines Teil-Netzwerkes von weiteren Konstruktionseinheiten festlegt, wobei die Konstruktions-Datenbank ferner auch eine Mehrzahl von vorher kompilierten Teil-Modellen aufnimmt, um entsprechende Konstruktionseinheiten zu simulieren,
b) die Netzwerk-Objekte in der Konstruktions-Datenbank verwendet werden, um eine ausgewählte Konstruktionseinheit als Teil-Netzwerk zusätzlicher Konstrunktionseinheiten zu erweitern, und eine Liste von kompilierten Teil-Modellen erzeugt wird, die in der Konstruktions-Datenbank zum Simulieren dieser weiteren Konstruktions-Einheiten gespeichert werden, und
c) die kompilierten Teil-Modelle auf der Liste miteinander verkettet werden, um ein kompiliertes Simulationsmodell für die ausgewählte Konstruktionseinheit zu erzeugen.

## Revendications

1. Système d'ordinateur pour générer un modèle de simulation d'un système électronique numérique constitué par une pluralité d'unités de conception, le système d'ordinateur comprenant :
a) une base de données de conception qui stocke une pluralité d'objets de réseau, chaque objet de réseau définissant l'une desdites unités de conception en termes d'un sous-réseau d'unités de conception supplémentaires, la base de données de conception stockant également une pluralité de sous-modèles compilés préalablement pour simuler des unités de conception respectives ;
b) un moyen de compilation pour utiliser lesdits objets de réseau dans la base de données de conception afin d'étendre une unité de conception sélectionnée en tant que sous-réseau d'unités de conception supplémentaires et pour générer une liste de sous-modèles compilés stockés dans ladite base de données de conception pour simuler ces unités de conception supplémentaires ; et
c) un moyen de liaison pour lier ensemble les sous-modèles compilés sur ladite liste afin de produire un modèle de simulation compilé pour ladite unité de conception sélectionnée.

2. Système d'ordinateur selon la revendication 1, comprenant en outre un moyen pour mettre à jour un modèle de simulation existant suite à une modification apportée au niveau d'un sous-modèle qui en fait partie, en liant une version ultérieure d'un sous-modèle dans le modèle de simulation en lieu et place d'un sous-modèle existant.

3. Système d'ordinateur selon la revendication 1 ou 2, incluant en outre un fichier d'aiguillage comprenant un jeu d'instructions dont chacune spécifie si une unité de conception doit être étendue ou non en tant que sous-réseau, représenté en termes de sa spécification de comportement, simulé au moyen d'un sous-modèle compilé préalablement ou compilé concurremment en tant que spécification comportementale agencée en parallèle avec ledit sous-modèle ou ledit sous-réseau.

4. Procédé de génération d'un modèle de simulation d'un système électronique numérique constitué par une pluralité d'unités de conception, le procédé comprenant les étapes de :
a) création d'une base de données de conception qui contient une pluralité d'objets de réseau, chaque objet de réseau définissant l'une desdites unités de conception en termes d'un sous-réseau d'unités de conception supplémentaires, la base de données de conception contenant également une pluralité de sous-modèles compilés préalablement pour simuler des unités de conception respectives ;
b) utilisation desdits objets de réseau dans la base de données de conception afin d'étendre une unité de conception sélectionnée en tant que sous-réseau d'unités de conception supplémentaires et génération d'une liste de sous-modèles compilés stockés dans ladite base de données de conception pour simuler ces unités de conception supplémentaires ; et
c) liaison ensemble des sous-modèles compilés sur ladite liste afin de produire un modèle de simulation compilé pour ladite unité de conception sélectionnée.
